# FASCICULE DE BREVET EUROPEEN

(11) **EP 1 005 159 B1**
(45) Date de publication et mention de la délivrance du brevet: **24.10.2007**
(21) Numéro de dépôt: 99410104.6
(22) Date de dépôt: 24.08.1999
(51) Int. Cl.: H03K 17/16, H03K 17/732

(54) **Circuit de commutation**
Schaltkreis
Switching circuit

(30) Priorité: 28.08.1998 FR 9810929
(43) Date de publication de la demande: 31.05.2000
(73) Titulaire: STMicroelectronics S.A., 92120 Montrouge (FR)
(72) Inventeur: Guitton, Fabrice, 37200 Tours (FR); Magnon, Didier, 86130 Saint George les Baillargeaux (FR); Simonnet, Jean-Michel, 37270 Veretz (FR); Ladiray, Olivier, 37270 Montlouis sur Loire (FR)
(74) Mandataire: de Beaumont, Michel

(56) Documents cités:
- WO-A-98/24181
- US-A- 3 899 713
- US-A- 4 489 340
- TSAY C L ET AL: "A HIGH POWER CIRCUIT MODEL FOR THE GATE TURN OFF THYRISTOR" PROCEEDINGS OF THE ANNUAL POWER ELECTRONICS SPECIALISTS CONFERENCE (PESC), SAN ANTONIO, JUNE 11 - 14, 1990, vol. 1, no. CONF. 21, 11 juin 1990 (1990-06-11), pages 390-397, XP000173903 INSTITUTE OF ELECTRICAL AND ELECTRONICS ENGINEERS

## Description

La présente invention telle que définie dans les revendications indépendante, concerne de façon genérale le domaine des commutateurs et plus particulièrement la réalisation de commutateurs propres à commuter un circuit connecté au secteur d'une façon compatible avec les normes actuelles relatives aux perturbations électromagnétiques.

Pour commuter une tension secteur élevée, on utilise couramment des commutateurs de type thyristor qui sont normalement ouverts (qui doivent être commandés pour se fermer) ou des montages qui sont normalement fermés (qui doivent être commandés pour s'ouvrir). La commande, à la fermeture ou à l'ouverture, de ces commutateurs entraîne une forte variation du courant pendant un intervalle de temps très bref. Cette variation brutale est susceptible de provoquer des perturbations électromagnétiques au niveau d'équipements voisins.

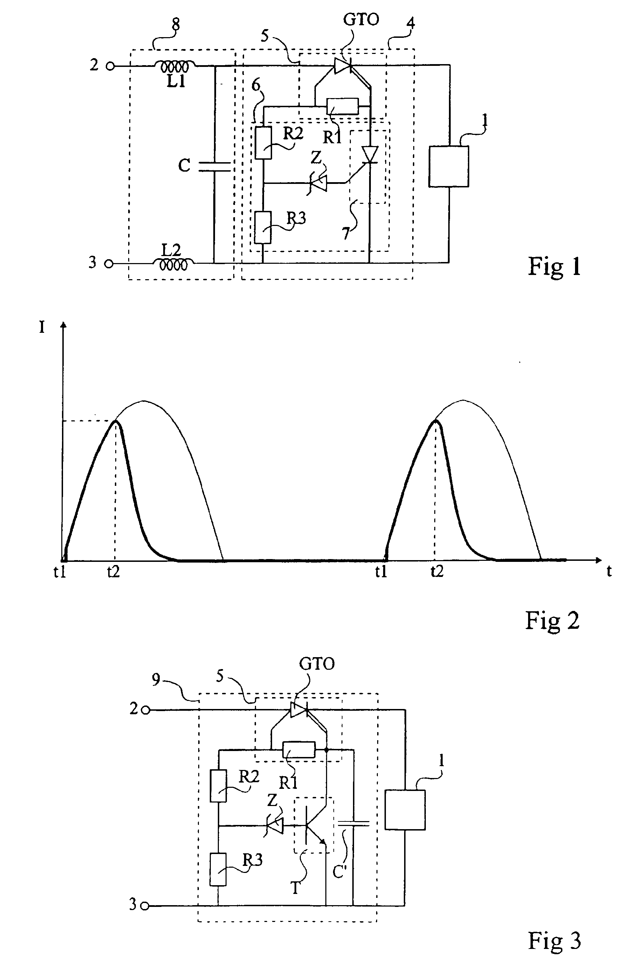

La figure 1 illustre un exemple de montage à commutateur normalement fermé. On cherche ici à commander l'alimentation d'une charge 1 destinée à recevoir une partie de la puissance que peut fournir une source de tension d'alimentation alternative Vac, par exemple la tension du secteur, appliquée entre deux bornes 2, 3. La puissance fournie à la charge 1 est commandée par un circuit de commutation 4. Le circuit 4 comprend un commutateur 5 et un circuit de commande 6. Le commutateur 5 est un thyristor ouvrable par la gâchette (GTO), muni de gâchettes d'anode et de cathode qui sont connectées par une résistance R1.

La figure 2 représente l'allure du courant I dans la charge en fonction du temps. Grâce à la présence de la résistance R1, le thyristor GTO se ferme naturellement au début de chaque alternance positive de la tension Vac (instants tl). Le circuit 6 a pour objet de provoquer l'ouverture du thyristor GTO lorsque la tension d'alimentation Vac atteint un niveau prédéterminé. Dans l'exemple de réalisation illustré, le circuit 6 comprend une diode de référence ou diode à avalanche Z dont la cathode est connectée au point milieu d'un pont de résistances R2, R3. Les valeurs des résistances R2, R3 sont choisies pour que la diode Z passe en avalanche lorsque la tension Vac atteint le niveau auquel on souhaite interrompre l'alimentation de la charge 1. Entre la gâchette de cathode du thyristor GTO et la borne 3, est connecté un interrupteur 7, par exemple un thyristor, qui se ferme quand la diode Z devient passante, à la suite de quoi le commutateur 5 s'ouvre (instants t2) et le courant dans la charge chute brusquement à zéro, comme cela est illustré en figure 2 en pointillés. Ensuite, le courant demeure nul jusqu'au début de l'alternance positive suivante où cette séquence se répète.

Comme cela a été mentionné précédemment, la variation brusque du courant sur la ligne d'alimentation aux instants t2 peut provoquer des perturbations électromagnétiques.

Pour résoudre ce problème, on prévoit classiquement entre chacune des bornes 2, 3 et le circuit 4 un filtre passe-bas 8. Le filtre 8 comprend par exemple des inductances L1 et L2 et un condensateur C. Une première extrémité de chacune des inductances L1, L2 est connectée à une des bornes respectives 2, 3. Les secondes extrémités des inductances L1 et L2 sont connectées par le condensateur C et sont reliées respectivement aux bornes du circuit série comprenant le thyristor GTO et la charge 1. Pour un courant commuté de 1 A, les valeurs des inductances L1, L2 sont typiquement de l'ordre de 150 µH, et la capacité du condensateur C est typiquement de 470 nF. Un inconvénient de ce type de solution classique est qu'un tel filtre 8 est encombrant, non intégrable et cher.

Le brevet américain 3899713 décrit un circuit comprenant un commutateur (102, figure 2) qui peut être un thyristor (104) à gâchette de cathode (108). Ce thyristor est décrit uniquement à titre d'exemple de commutateurs. Sa fonction de thyristor ouvrable par la gâchette (GTO) n'est pas utilisée. En particulier, ce brevet décrit colonnes 13 et 14 que le commutateur 102 est normalement ouvert.

La présente invention vise à proposer un nouveau circuit de commutation qui puisse être utilisé sans filtre.

La présente invention vise également à proposer un tel circuit de commutation qui soit, pour l'essentiel, réalisable sous forme d'un composant monolithique.

Pour atteindre ces objets, la présente invention prévoit un circuit de commutation de type comprenant un thyristor ouvrable par la gâchette polarisé de façon à être normalement fermé, comportant en outre, entre la gâchette et une ligne d'alimentation, un condensateur et un commutateur commandable connectés en parallèle.

Selon un mode de réalisation de la présente invention, le commutateur commandable est un transistor bipolaire.

Selon un mode de réalisation de la présente invention, les gâchettes d'anode et de cathode du thyristor sont interconnectées par l'intermédiaire d'une résistance.

Selon un mode de réalisation de la présente invention, une borne de commande du commutateur est connectée à l'anode d'une diode de référence dont la cathode est connectée au point milieu d'un pont de résistances.

La présente invention prévoit également un circuit de commutation bidirectionnel constitué de l'association en antiparallèle de deux circuits de commutation selon l'un quelconque des modes de réalisation précédents.

La présente invention prévoit également un circuit de commutation réalisé sous forme monolithique dans un substrat semiconducteur d'un premier type de conductivité comportant des première et seconde zones délimitées par des premier et second murs d'isolement, la première zone comprenant le thyristor réalisé sous forme latérale, sa gâchette de cathode étant connectée au premier mur, et comprenant le pont de résistances ; la deuxième zone comprenant le commutateur et la diode, le commutateur étant un transistor bipolaire formé verticalement ; et la face arrière de la première zone étant revêtue d'une couche isolante laissant libre une partie au moins de la face arrière du premier mur, une métallisation recouvrant l'ensemble de la face arrière et assurant avec le premier mur d'isolement une connexion entre la gâchette de cathode du thyristor et le collecteur du transistor.

Selon un mode de réalisation de la présente invention, le circuit de commutation réalisé sous forme monolithique comprend du côté de la face supérieure du substrat, de type N :
- dans la première zone :
   une première région d'anode de type P fortement dopée recouverte d'une première métallisation ;
   une deuxième région de cathode de type N fortement dopée recouverte d'une deuxième métallisation ;
   une troisième région de type N fortement dopée, revêtue d'une troisième métallisation et en contact avec le substrat, correspondant à la gâchette d'anode ;
   une quatrième région de gâchette de cathode de type P fortement dopée, en contact avec le premier mur d'isolement ;
   une cinquième région de type P fortement dopée, en court-circuit, par la troisième métallisation, avec la troisième région, et en contact avec une sixième région de type P faiblement dopée, la sixième région étant en outre en contact avec la quatrième région et constituant une résistance entre les gâchettes d'anode et de cathode ;
   des régions de type P faiblement dopées, dont les extrémités sont solidaires de régions de type P fortement dopées revêtues de métallisations respectives, une des métallisations court-circuitant une région de type P, correspondant à une des résistances du pont de résistances, et une région de type N fortement dopée ; et
- dans la seconde région :
   un caisson de type P faiblement dopé, constituant la base du transistor, dans lequel sont formées des régions de type N fortement dopées, recouvertes de métallisations respectives, correspondant à l'émetteur du transistor et à la cathode de la diode ; et
   du côté de la face arrière du substrat, une région de type N fortement dopée constituant le collecteur du transistor.

Selon un mode de réalisation de la présente invention, la seconde zone comprend du côté de la face supérieure un anneau d'arrêt de canal de type N fortement dopé à la périphérie du caisson, l'anneau étant recouvert d'une métallisation.

La présente invention prévoit également un circuit de commutation réalisé sous forme monolithique dans un substrat semiconducteur d'un premier type de conductivité comportant des première et seconde zones délimitées par des murs d'isolement ; la première zone comprenant le thyristor réalisé sous forme latérale et le pont de résistances ; la deuxième zone comprenant le commutateur et la diode, le commutateur étant un transistor bipolaire formé latéralement ; la connexion entre la gâchette de cathode du thyristor et le collecteur du transistor étant assurée du côté de la face avant.

Selon un mode de réalisation de la présente invention, le circuit de commutation réalisé sous forme monolithique comprend du côté de la face supérieure du substrat, de type N :
- dans la première zone :
   une première région d'anode de type P fortement dopée recouverte d'une première métallisation ;
   une deuxième région de cathode de type N fortement dopée recouverte d'une deuxième métallisation ;
   une troisième région de type N fortement dopée, revêtue d'une troisième métallisation et en contact avec le substrat, correspondant à la gâchette d'anode ;
   une quatrième région de gâchette de cathode de type P fortement dopée, disjointe du premier mur d'isolement ;
   une région d'arrêt de canal entre la quatrième région et le premier mur ;
   une cinquième région de type P fortement dopée, en court-circuit, par la troisième métallisation, avec la troisième région, et en contact avec une sixième région de type P faiblement dopée, la sixième région étant en outre en contact avec la quatrième région et constituant une résistance entre les gâchettes d'anode et de cathode ;
   des régions de type P faiblement dopées, dont les extrémités sont solidaires de régions de type P fortement dopées revêtues de métallisations respectives, une des métallisations court-circuitant une région de type P, correspondant à une des résistances du pont de résistances, et une région de type N fortement dopée ; et
- dans la seconde région :
   un caisson de type P faiblement dopé, constituant la base du transistor, dans lequel sont formées des régions de type N fortement dopées, recouvertes de métallisations respectives, correspondant à l'émetteur du transistor et à la cathode de la diode ; et
   à la périphérie du caisson, un anneau de type N fortement dopé recouvert d'une métallisation, constituant le collecteur du transistor.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un mode de réalisation d'un circuit de commutation selon l'art antérieur ;
La figure 2 illustre les variations du courant de ligne dans le cas du circuit de la figure 1 et dans le cas d'un circuit de commutation selon la présente invention ;
la figure 3 représente un mode de réalisation d'un circuit de commutation selon la présente invention ;
la figure 4 est une vue en coupe schématique représentant un premier exemple de réalisation monolithique d'un circuit selon la présente invention ; et
la figure 5 est une vue en coupe schématique représentant un second exemple de réalisation monolithique d'un circuit selon la présente invention.

Pour des raisons de clarté, les mêmes éléments ont été désignés par les mêmes références aux différentes figures. De plus, comme cela est habituel dans la représentation des circuits intégrés, les différentes vues en coupe ne sont pas à l'échelle.

La présente invention prévoit de contrôler la décroissance du courant au moment de l'ouverture d'un commutateur normalement conducteur.

La figure 3 illustre un mode de réalisation de la présente invention. On cherche à limiter aux bornes d'une charge 1 la puissance fournie par une source de tension d'alimentation Vac, par exemple la tension secteur de 220 volts, délivrée entre des bornes 2 et 3. Pour ce faire, on utilise un circuit de commutation 9 selon la présente invention.

Le circuit 9 comprend, comme le circuit 4 de la figure 1, un commutateur 5, une résistance R1, une diode de référence Z et un pont de résistances R2, R3 montés comme les éléments de mêmes références de la figure 1.

Selon la présente invention, le thyristor 7 est remplacé par un transistor bipolaire T et le circuit 9 comprend en outre, en parallèle avec le transistor T, un condensateur C'. Le fonctionnement du circuit de commutation selon l'invention apparaîtra plus clairement ci-après.

Les valeurs des différents composants sont, par exemple, pour un courant commuté de 1 A dans une charge de 50 Ω, une diode Z d'un seuil de 10 V, une résistance R2 de 90 kΩ, une résistance R3 de 240 kΩ et un condensateur C' d'une capacité de 22 nF.

Comme l'illustre la figure 2, au début d'une alternance positive de la tension Vac, le commutateur 5 se ferme de la même façon que dans le circuit 4 de la figure 1. Le courant de ligne I est identique dans cette première phase à celui du circuit classique.

Une fois le commutateur 5 fermé, le condensateur C' se charge. La tension à ses bornes suit donc sensiblement la tension d'alimentation.

Comme précédemment, lorsque la tension Vac atteint un niveau prédéterminé, la diode à avalanche Z devient passante et un courant apparaît sur la base du transistor T. Toutefois, comme l'illustre en trait plein la figure 2, le condensateur C' selon l'invention se décharge par le collecteur du transistor T. Tant que le transistor T n'est pas saturé, cette décharge est sinusoïdale. En effet, le courant de collecteur du transistor T suit son courant de base qui est fonction de la tension (sinusoïdale) du secteur. Une fois le transistor T saturé, cette décharge se fait exponentiellement jusqu'à ce que le condensateur soit totalement déchargé. Alors, le courant s'annule et le commutateur 5 est complètement ouvert. Le transistor T reste saturé jusqu'à la fin de l'alternance positive, ce qui maintient bloqué le commutateur 5.

Un avantage de la présente invention est donc que l'ouverture du commutateur 5 est progressive et s'accompagne d'une variation relativement lente du courant de ligne, comme l'illustre la figure 2, limitant ainsi de façon importante les perturbations électromagnétiques sur les équipements voisins.

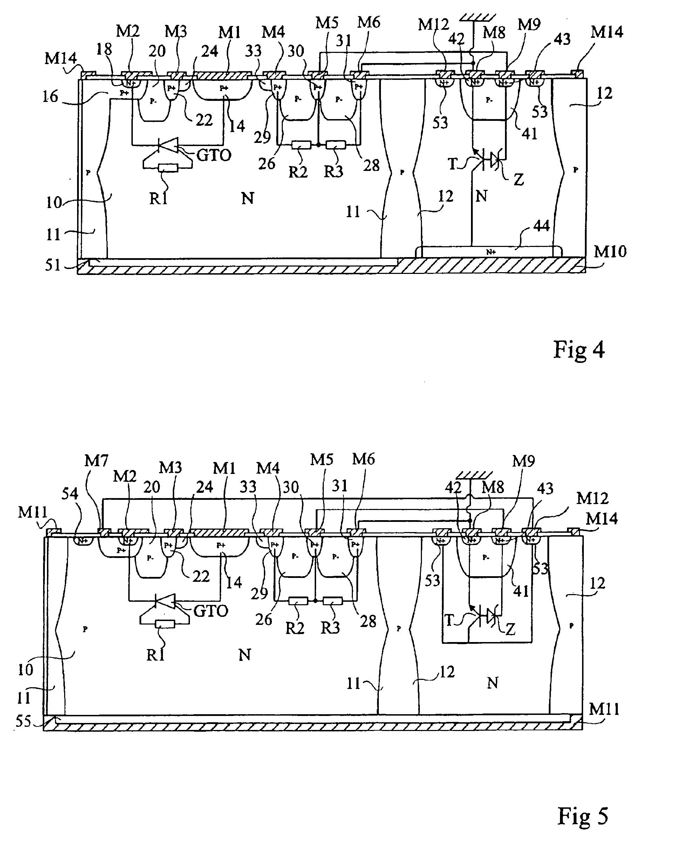

La figure 4 est une vue en coupe schématique représentant un premier exemple de réalisation sous forme monolithique du circuit de la figure 3.

Le circuit de commutation 9 est réalisé sous forme monolithique, à l'exception du condensateur C', dans un substrat semiconducteur 10, par exemple en silicium, d'un premier type de conductivité, par exemple N.

Dans ce substrat sont délimitées une première zone entourée d'un mur d'isolement 11 et une deuxième zone entourée d'un mur d'isolement 12. Dans l'exemple de réalisation représenté, ces zones sont adjacentes et une portion du mur d'isolement 11 se confond donc avec une portion du mur d'isolement 12. De façon classique, ce mur d'isolement est réalisé par diffusion profonde d'un dopant P à partir des deux faces du substrat.

Dans la première zone sont formées, du côté de la face supérieure, une première région 14 de type P⁺, une deuxième région 16 de type P⁺ et une région 18 de type N⁺ à l'intérieur de la région 16. L'ensemble de ces régions constitue un thyristor latéral dans lequel la région 14 correspond à l'anode, le substrat 10 à la gâchette d'anode, la région 16 à la gâchette de cathode et la région 18 à la cathode. De façon classique, pour que le thyristor puisse facilement s'ouvrir par la gâchette, la cathode aura une faible largeur et une grande longueur. Pour rendre ce thyristor normalement passant et constituer l'équivalent de la résistance R1 représentée à la figure 3, on forme en outre, en contact avec la région P⁺ 18 une région 20 de type P faiblement dopée dont un deuxième contact est formé par une autre région de type P⁺ 22, elle-même en court-circuit avec une région de type N⁺ 24 formée dans le substrat 10.

Dans la première zone, on forme, également du côté de la face supérieure, des régions de type P faiblement dopées 26 et 28, par exemple en forme de bandes, destinées à constituer les résistances R2 et R3. Les extrémités de ces bandes sont solidaires de régions de type P fortement dopées 29, 30 et 31. La résistance R2 est par exemple formée entre les régions 29 et 30 et la résistance R3 entre les régions 30 et 31.

Pour réaliser les divers contacts mentionnés en figure 3, la région d'anode 14 est revêtue d'une métallisation M1 et la région de cathode 18 est revêtue d'une métallisation M2. Une métallisation M3 établit le court-circuit entre les régions P 22 et N 24. La liaison entre la gâchette d'anode du thyristor GTO et une borne de la résistance R2 est assurée par une métallisation M4 qui relie la région de type P 29 à une zone 33 de type N fortement dopée formée dans le substrat qui, comme on l'a vu précédemment, correspond à la gâchette d'anode du thyristor latéral GTO. Le point milieu des résistances R2 et R3 est relié à une métallisation M5 et la deuxième borne de la résistance R3 est reliée à une métallisation M6.

Dans la deuxième zone, du côté droit de la figure 4, sont formés le transistor NPN T et la diode à avalanche Z. On a formé, du côté de la face supérieure, un caisson de type P 41 dans lequel sont formées des régions de type N 42 et 43. Du côté de la face arrière est formée une région 44 de type N fortement dopée. On obtient ainsi le transistor NPN T dont l'émetteur correspond à la région 42, la base à la région 41 et le collecteur au substrat 10 et à la région de type N 44. La diode Z correspond à la jonction entre la région N 43 et le caisson P 41. Une métallisation M8 formée sur la région 42 correspond à l'émetteur du transistor et une métallisation M9 formée sur la région 43 correspond à la cathode de la diode Z. La métallisation M8 est reliée à la métallisation M6 précédemment décrite et à la masse tandis que la métallisation M9 est reliée à la métallisation M5 précédemment décrite. En pratique, comme cela est connu de l'homme de l'art, les métallisations M6 et M8 constitueront de préférence une seule et même métallisation, de même que les métallisations M5 et M9.

Pour assurer la connexion entre la gâchette de cathode (région 16) du thyristor GTO et le collecteur (région 44) du transistor T, on utilise le mur d'isolement 11. Ce mur d'isolement 11 est relié à la région 16. Dans le mode de réalisation représenté, cette liaison est assurée par une continuité entre le mur d'isolement et cette région 16. On pourrait également prévoir des régions disjointes connectées par une métallisation. En outre, du côté de la face arrière du substrat, une couche isolante 51 est déposée en regard de la première zone. Cette couche isolante laisse libre une partie au moins de la face arrière du mur 11. Une métallisation M10 recouvre l'ensemble de la face arrière et assure donc la fonction de connexion précédemment mentionnée.

Comme cela a été indiqué précédemment, la réalisation monolithique décrite ci-dessus ne comprend pas le condensateur C'. Celui-ci pourra être connecté par une première borne à la borne de masse reliée à la métallisation M8 et par la deuxième borne à la métallisation de face arrière M10. On pourra également prévoir une métallisation M14 formée du côté de la face supérieure du substrat sur les murs d'isolement et à laquelle sera connectée la deuxième borne du condensateur. En ce cas, la métallisation M10 a pour seule fonction d'assurer la connexion entre gâchette de cathode du thyristor GTO et collecteur du transistor T et n'est pas destinée à être connectée à une borne externe. Elle servira simplement au montage du composant comme cela est le cas pour de nombreux composants de puissance destinés à être connectés à un radiateur.

Le mode de réalisation de la figure 4 est susceptible de diverses variantes et modifications qui apparaîtront à l'homme de l'art qui pourra apporter aux divers éléments des modifications classiques pour améliorer leurs fonctions ou assurer des fonctions supplémentaires. D'autre part, la structure représentée en figure 4 peut constituer l'ensemble d'un composant monolithique ou constituer une partie d'un composant monolithique plus vaste dont d'autres éléments s'étendraient dans le substrat 10 en dehors des parties représentées et délimitées par les murs d'isolement 11 et 12. A titre d'exemple d'une variante possible de l'invention, on a représenté en figure 4 la formation d'un anneau de type N fortement dopé, à partir de la face supérieure du substrat ayant une fonction d'arrêt de canal. Cet anneau est désigné par la référence 53 et peut être revêtu d'une métallisation M12.

La figure 5 illustre un deuxième exemple de réalisation sous forme monolithique du circuit de la figure 3.

Du côté gauche, le pont de résistances R2, R3, la résistance R1 et le thyristor GTO sont formés de la même façon que celle décrite précédemment en relation avec la figure 5. Toutefois, la région 16 constituant la gâchette de cathode du thyristor GTO est maintenant disjointe du mur d'isolement 11. On pourra alors prévoir une région N' 54 d'arrêt de canal entre la région 16 et le mur 11. On forme alors au-dessus de la région 16 une métallisation M7.

Du côté droit de la figure 5, le transistor bipolaire T de type NPN est formé latéralement. Sa base et son émetteur, ainsi que la diode Z, sont formés de la même façon que celle décrite précédemment en relation avec la figure 4. Le collecteur du transistor T correspond maintenant à l'anneau N⁺ 53 formé à la périphérie du caisson de base 41. On prévoit alors une métallisation de collecteur M12 sur cet anneau 53.

Les diverses connexions sont effectuées de la même façon que celle décrite précédemment en relation avec la figure 4. Toutefois, la connexion entre la gâchette de cathode du thyristor GTO (région 16) et le collecteur est maintenant effectuée par une liaison des métallisations M7 et M12.

En outre, du côté de la face arrière du substrat 10, une couche isolante 55 est déposée. Une métallisation M11 recouvre l'ensemble de la face arrière sauf éventuellement la face arrière des murs d'isolement et a pour fonction de servir au montage du composant comme cela est le cas pour de nombreux composants de puissance destinés à être connectés à un radiateur.

Comme cela a été indiqué précédemment, la réalisation monolithique décrite ci-dessus ne comprend pas le condensateur C'. Celui-ci sera connecté entre la borne de masse reliée à la métallisation M8 et la métallisation M12.

Un avantage de ce second mode de réalisation est de permettre d'isoler complètement les deux zones formées dans le substrat, ce qui évite l'apparition de jonctions parasites supplémentaires.

Un avantage de la présente invention est que le circuit de commutation (9, figure 3) est intégrable, si ce n'est le condensateur C' (figure 3). Toutefois, le condensateur C' a un encombrement relativement limité. En effet, alors que le filtre utilisé classiquement (8, figure 1) faisait appel à deux inductances (Ll, L2) et à un condensateur (C) très encombrants, le circuit selon l'invention n'utilise plus qu'un seul condensateur (C' en figure 3) dont la capacité est très inférieure à celle du condensateur d'un filtre classique.

En effet, le condensateur C est un composant de filtrage, dont la valeur est calculée en fonction des inductances L1 et L2 mais également en fonction de la perte d'insertion (ou de l'atténuation fréquentielle) désirée. Par contre, le condensateur C' n'est pas un composant de filtrage mais est utilisé comme un générateur de tension commandé par le transistor T.

Le circuit unidirectionnel selon la présente invention décrit précédemment en relation avec les figures 2 à 6 peut être avantageusement utilisé pour réaliser un commutateur bidirectionnel propre à commuter un circuit connecté au secteur d'une façon compatible avec les normes actuelles relatives aux perturbations électromagnétiques. Pour ce faire, on utilisera, connectés en antiparallèle entre deux bornes d'alimentation d'une charge, deux commutateurs unidirectionnels selon la présente invention d'une façon qui apparaîtra clairement à l'homme de l'art.

Bien entendu, la présente invention est susceptible de diverses variantes et modifications qui apparaîtront à l'homme de l'art. En particulier, la résistance R2 peut être une résistance réglable, pour permettre des applications de gradateurs ou adapter la valeur seuil d'ouverture du thyristor GTO. De plus, le commutateur représenté à titre d'exemple sous la forme d'un transistor bipolaire (T) peut être un quelconque de divers commutateurs linéaires commandables à la fermeture connus dans la technique.

## Revendications

1. Circuit de commutation unidirectionnel de type comprenant un thyristor (GTO) ouvrable par la gâchette polarisé de façon à être normalement fermé, **caractérisé en ce qu'**il comporte en outre, entre la gâchette et une ligne d'alimentation, un condensateur (C') et un commutateur commandable (T) connectés en parallèle, le commutateur présentant un régime linéaire au moins dans une première phase de sa fermeture.

2. Circuit selon la revendication 1, **caractérisé en ce que** le commutateur commandable (T) est un transistor bipolaire.

3. Circuit selon la revendication 1 ou 2, **caractérisé en ce que** les gâchettes d'anode et de cathode du thyristor (GTO) sont interconnectées par l'intermédiaire d'une résistance (R1).

4. Circuit selon l'une quelconque des revendications 1 à 3, **caractérisé en ce qu'**une borne de commande du commutateur (T) est connectée à l'anode d'une diode de référence (Z) dont la cathode est connectée au point milieu d'un pont de résistances (R2, R3).

5. Circuit de commutation bidirectionnel, **caractérisé en ce qu'**il est constitué de l'association en antiparallèle de deux circuits de commutation selon l'une quelconque des revendications 1 à 4.

6. Circuit selon la revendication 4 réalisé sous forme monolithique dans un substrat (10) semiconducteur d'un premier type de conductivité, **caractérisé en ce qu'**il comporte des première et seconde zones délimitées par des premier (11) et second (12) murs d'isolement :
la première zone comprenant le thyristor (GTO) réalisé sous forme latérale, sa gâchette de cathode étant connectée au premier mur, et comprenant le pont de résistances (R2, R3) ;
la deuxième zone comprenant le commutateur (T) et la diode (Z), le commutateur étant un transistor bipolaire formé verticalement ; et
la face arrière de la première zone étant revêtue d'une couche isolante (51) laissant libre une partie au moins de la face arrière du premier mur, une métallisation (M10) recouvrant l'ensemble de la face arrière et assurant avec le premier mur d'isolement une connexion entre la gâchette de cathode (16) du thyristor et le collecteur (44) du transistor.

7. Circuit selon la revendication 6, **caractérisé en ce qu'**il comprend du côté de la face supérieure du substrat (10), de type N :
- dans ladite première zone :
une première région (14) d'anode de type P fortement dopée recouverte d'une première métallisation (M1) ;
une deuxième région (18) de cathode de type N fortement dopée recouverte d'une deuxième métallisation (M2) ;
une troisième région (24) de type N fortement dopée, revêtue d'une troisième métallisation (M3) et en contact avec le substrat (10), correspondant à la gâchette d'anode ;
une quatrième région (16) de gâchette de cathode de type P fortement dopée, en contact avec le premier mur d'isolement (11) ;
une cinquième région (22) de type P fortement dopée, en court-circuit, par la troisième métallisation (M3), avec la troisième région (24), et en contact avec une sixième région (20) de type P faiblement dopée, la sixième région étant en outre en contact avec la quatrième région (16) et constituant une résistance (R1) entre les gâchettes d'anode et de cathode ;
des régions (26, 28) de type P faiblement dopées, dont les extrémités sont solidaires de régions (29, 30 et 31) de type P fortement dopées revêtues de métallisations respectives (M4, M5 et M6), une des métallisations (M4) court-circuitant une région (29) de type P, correspondant à une (R2) des résistances du pont de résistances (R2, R3), et une région (33) de type N fortement dopée ; et
- dans ladite seconde région :
un caisson (41) de type P faiblement dopé, constituant la base du transistor (T), dans lequel sont formées des régions (42, 43) de type N fortement dopées, recouvertes de métallisations respectives (M8, M9), correspondant à l'émetteur du transistor et à la cathode de la diode (Z) ;
et **en ce qu'**il comprend, dans ladite seconde région, du côté de la face arrière du substrat, une région (44) de type N fortement dopée constituant le collecteur du transistor.

8. Circuit selon la revendication 7, **caractérisé en ce que** ladite seconde zone comprend du côté de la face supérieure un anneau (53) d'arrêt de canal de type N fortement dopé à la périphérie du caisson (41), l'anneau étant recouvert d'une métallisation (M12).

9. Circuit selon la revendication 4 réalisé sous forme monolithique dans un substrat (10) semiconducteur d'un premier type de conductivité, **caractérisé en ce qu'**il comporte des première et seconde zones délimitées par des murs d'isolement (11, 12) ;
la première zone comprenant le thyristor (GTO) réalisé sous forme latérale et le pont de résistances (R2, R3) ;
la deuxième zone comprenant le commutateur (T) et la diode (Z), le commutateur étant un transistor bipolaire formé latéralement ;
la connexion entre la gâchette de cathode (16) du thyristor et le collecteur (44) du transistor étant assurée du côté de la face avant.

10. Circuit selon la revendication 9, **caractérisé en ce qu'**il comprend du côté de la face supérieure du substrat (10), de type N :
- dans ladite première zone :
une première région (14) d'anode de type P fortement dopée recouverte d'une première métallisation (M1) ;
une deuxième région (18) de cathode de type N fortement dopée recouverte d'une deuxième métallisation (M2) ;
une troisième région (24) de type N fortement dopée, revêtue d'une troisième métallisation (M3) et en contact avec le substrat (10), correspondant à la gâchette d'anode ;
une quatrième région (16) de gâchette de cathode de type P fortement dopée, disjointe du premier mur d'isolement (11) ;
une région (54) d'arrêt de canal entre la quatrième région et le premier mur ;
une cinquième région (22) de type P fortement dopée, en court-circuit, par la troisième métallisation (M3), avec la troisième région (24), et en contact avec une sixième région (20) de type P faiblement dopée, la sixième région étant en outre en contact avec la quatrième région (16) et constituant une résistance (R1) entre les gâchettes d'anode et de cathode ;
des régions (26, 28) de type P faiblement dopées, dont les extrémités sont solidaires de régions (29, 30 et 31) de type P fortement dopées revêtues de métallisations respectives (M4, M5 et M6), une des métallisations (M4) court-circuitant une région (29) de type P, correspondant à une (R2) des résistances du pont de résistances (R2, R3), et une région (33) de type N fortement dopée ; et
- dans ladite seconde région :
un caisson (41) de type P faiblement dopé, constituant la base du transistor (T), dans lequel sont formées des régions (42, 43) de type N fortement dopées, recouvertes de métallisations respectives (M8, M9), correspondant à l'émetteur du transistor et à la cathode de la diode ; et
à la périphérie du caisson, un anneau (53) de type N fortement dopé recouvert d'une métallisation (M12), constituant le collecteur du transistor.

## Claims

1. A one-way switching circuit of the type including a gate turn-off thyristor (GTO) biased to be normally on, **characterized in that** it further includes, between the gate and a supply line, a capacitor (C') and a controllable switch (T) connected in parallel, the switch having a linear operation at least in a first phase of its turn on.

2. The circuit of claim 1, **characterized in that** the controllable switch (T) is a bipolar transistor.

3. The circuit of claim 1 or 2, **characterized in that** the anode and cathode gates of the thyristor (GTO) are interconnected via a resistor (R1).

4. The circuit of any of claims 1 to 3, **characterized in that** a control terminal of the switch (T) is connected to the anode of a reference diode (Z), the cathode of which is connected to the midpoint of a resistor bridge (R2, R3).

5. A bidirectional switching circuit, **characterized in that** it is formed of the antiparallel association of two switching circuits of any of claims 1 to 4.

6. The circuit of claim 4 made in monolithic form in a semiconductor substrate (10) of a first conductivity type, **characterized in that** it includes first and second areas defined by first (11) and second (12) insulating walls:
the first area including the thyristor (GTO) made in lateral form, its cathode gate being connected to the first wall, and including the resistor bridge (R2, R3);
the second area including the switch (T) and the diode (Z), the switch being a vertically-formed bipolar transistor; and
the rear surface of the first area being coated with an insulating layer (51) which lets free at least a portion of the rear surface of the first wall, a metallization (M10) covering the entire rear surface and ensuring with the first insulating wall a connection between the thyristor cathode gate (16) and the transistor collector (44).

7. The circuit of claim 6, **characterized in that** it includes, on the N-type upper surface side of the substrate (10):
- in the first area:
a first heavily-doped P-type anode region (14) covered with a first metallization (M1);
a second heavily-doped N-type cathode region (18) covered with a second metallization (M2);
a third heavily-doped N-type region (24), coated with a third metallization (M3) and in contact with the substrate (10), corresponding to the anode gate;
a fourth heavily-doped P-type cathode gate region (16), in contact with the first insulating wall (11);
a fifth heavily-doped P-type region (22), in short-circuit, through the third metallization (M3), with the third region (24), and in contact with a sixth lightly-doped P-type region (20), the sixth region further being in contact with the fourth region (16) and forming a resistor (R1) between the anode and cathode gates;
lightly-doped P-type regions (26, 28), the ends of which form one piece with heavily-doped P-type regions (29, 30, 31) coated with respective metallizations (M4, M5, M6), one of the metallizations (M4) short-circuiting a P-type region (29), corresponding to one (R2) of the resistors of the resistor bridge (R2, R3), and a heavily-doped N-type region (33); and
- in the second region:
a lightly-doped P-type well (41), forming the base of the transistor (T), in which are formed heavily-doped N-type regions (42, 43), covered with respective metallizations (M8, M9), corresponding to the emitter of the transistor and to the cathode of the diode (Z); and
on the rear surface side of the substrate, a heavily-doped N-type region (44) forming the collector of the transistor.

8. The circuit of claim 7, **characterized in that** the second area includes on the upper surface side a heavily-doped N-type channel stop ring (53) at the periphery of the well (41), the ring being covered with a metallization (M12).

9. The circuit of claim 4 made in monolithic form in a semiconductor substrate (10) of a first conductivity type, **characterized in that** it includes first and second areas defined by insulating walls (11, 12);
the first area including the thyristor (GTO) made in lateral form and the resistor bridge (R2, R3);
the second area including the switch (T) and the diode (Z), the switch being a laterally-formed bipolar transistor;
the connection between the thyristor cathode gate (16) and the transistor collector (44) being made on the front surface side.

10. The circuit of claim 9, **characterized in that** it includes on the N-type upper surface side of the substrate (10):
- in the first area:
a first heavily-doped P-type anode region (14) covered with a first metallization (M1);
a second heavily-doped N-type cathode region (18) covered with a second metallization (M2);
a third heavily-doped N-type region (24), coated with a third metallization (M3) and in contact with the substrate (10), corresponding to the anode gate;
a fourth heavily-doped P-type cathode gate region (16), separated from the first insulating wall (11);
a channel stop region (54) between the fourth region and the first wall;
a fifth heavily-doped P-type region (22), in short-circuit, through the third metallization (M3), with the third region (24), and in contact with a sixth lightly-doped P-type region (20), the sixth region further being in contact with the fourth region (16) and forming a resistor (R1) between the anode and cathode gates;
lightly-doped P-type regions (26, 28), the ends of which form one piece with heavily-doped P-type regions (29, 30, 31) coated with respective metallizations (M4, M5, M6), one of the metallizations (M4) short-circuiting a P-type region (29), corresponding to one (R2) of the resistors of the resistor bridge (R2, R3), and a heavily-doped N-type region (33); and
- in the second region:
a lightly-doped P-type well (41), forming the base of the transistor (T), in which are formed heavily-doped N-type regions (42, 43), covered with respective metallizations (M8, M9), corresponding to the emitter of the transistor and to the cathode of the diode; and
at the well periphery, a heavily-doped N-type ring (53) covered with a metallization (M12), forming the transistor collector.

## Patentansprüche

1. Einweg-Schaltkreis vom Typ, welcher einen über das Gate abschaltbaren und normalerweise in der eingeschalteten oder geschlossenen Stellung vorgespannten Thyristor (GTO) aufweist, **dadurch gekennzeichnet, dass** er ferner zwischen dem Gate und einer Versorgungsleitung einen Kondensator (C') und einen steuerbaren Schalter (T) aufweist, die parallel geschaltet sind, wobei der Schalter zumindest in einer ersten Schließphase ein lineares Verhalten zeigt.

2. Schaltkreis gemäß Anspruch 1, **dadurch gekennzeichnet, dass** der steuerbare Schalter (T) ein Bipolar-Transistor ist.

3. Schaltkreis nach Anspruch 1 oder 2, **dadurch gekennzeichnet, dass** die Anoden- und Kathoden-Anschlüsse des Thyristors (GTO) über einen Widerstand (R1) miteinander verbunden sind.

4. Schaltkreis nach einem der Ansprüche 1 bis 3, **dadurch gekennzeichnet, dass** ein Steueranschluß des Schalters (T) mit der Anode einer Referenzdiode (Z) verbunden ist, dessen Kathode mit dem Mittelpunkt einer Widerstandsbrücke (R2, R3) verbunden ist.

5. Zweiwege-Schaltkreis, **dadurch gekennzeichnet, dass** er gebildet ist durch antiparallele oder gegenläufige Anordnung zweier Schaltkreise gemäß einem der Ansprüche 1 bis 4.

6. Schaltkreis nach Anspruch 4, realisiert in monolithischer Form auf einem Halbleitersubstrat (10) mit einem ersten Leitungstyp, **dadurch gekennzeichnet, dass** er erste und zweite Bereiche besitzt, die durch erste (11) und zweite (12) Trenn- oder Isolationswände begrenzt sind; wobei der erste Bereich den Thyristor (GTO), realisiert in lateraler Form, aufweist, wobei dessen Kathoden-Anschluss mit der ersten Wand verbunden ist, sowie die Widerstandsbrücke (R2, R3) aufweist; wobei der zweite Bereich den Schalter (T) und die Diode (Z) aufweist, wobei der Schalter ein vertikal gebildeter Bipolar-Transistor ist; und wobei die Rückseite des ersten Bereichs mit einer Trenn- oder Isolationsschicht (51) beschichtet ist, die mindestens einen Teil der Rückseite der ersten Wand frei lässt, wobei eine Metallisierung (M10) die gesamte Rückseite bedeckt und zusammen mit der ersten Trenn- oder Isolationswand eine Verbindung zwischen dem Kathoden-Anschluss (16) des Thyristors und dem Kollektor (44) des Transistors gewährleistet.

7. Schaltkreis nach Anspruch 6, **dadurch gekennzeichnet, dass** er auf der N-Typ-Oberseite des Substrats (10) folgendes aufweist:
- in dem ersten Bereich:
eine erste, stark P-dotierte Anoden-Region (14), die mit einer ersten Metallisierung (M1) bedeckt ist;
eine zweite, stark N-dotierte Kathoden-Region (18), die mit einer zweiten Metallisierung (M2) bedeckt ist;
eine dritte, stark N-dotierte Region (24), die mit einer dritten Metallisierung (M3) beschichtet ist und in Kontakt mit dem Substrat (10) steht und dem Anoden-Anschluss entspricht;
eine vierte, stark P-dotierte Kathoden-Anschluss-Region (16), die in Kontakt mit der ersten Trenn- oder Isolationswand (11) steht;
eine fünfte, stark P-dotierte Region (22), die über die dritte Metallisierung (M3) mit der dritten Region (24) kurzgeschlossen ist und mit einer sechsten, schwach P-dotierten Region (20) in Kontakt steht, wobei die sechste Region ferner mit der vierten Region (16) in Kontakt steht und einen Widerstand (R1) zwischen dem Anoden- und dem Kathoden-Anschluss bildet;
schwach P-dotierte Regionen (26, 28), deren Ränder oder Enden einheitlich mit stark P-dotierten Bereichen (29, 30 und 31) sind, die mit jeweiligen Metallisierungen (M4, M5 und M6) beschichtet sind,
wobei eine der Metallisierungen (M4) eine P-dotierte Region (29), welche einem (R2) der Widerstände der Widerstandsbrücke (R2, R3) entspricht, und eine stark N-dotierte Region (33) kurzschließt; und
- in dem zweiten Bereich:
eine schwach P-dotierte Senke (41), die die Basis des Transistors (T) bildet und in der stark N-dotierte Regionen (42, 43) gebildet sind, die mit jeweiligen Metallisierungen (M8, M9) bedeckt sind und dem Emitter des Transistors und der Kathode der Diode (Z) entsprechen;
und daß er in der zweiten Region auf der Rückseite des Substrats eine stark N-dotierte Region (44) aufweist, die den Kollektor des Transistors bildet.

8. Schaltkreis nach Anspruch 7, **dadurch gekennzeichnet, dass** der zweite Bereich auf der Oberseite um den Umfang der Senke (41) herum einen stark N-dotierten Kanal-Stopp-Ring (53) aufweist, der mit einer Metallisierung (M12) bedeckt ist.

9. Schaltkreis nach Anspruch 4, realisiert in monolithischer Form auf einem Halbleitersubstrat (10) mit einem ersten Leitungstyp, **dadurch gekennzeichnet, dass** er erste und zweite Bereiche besitzt, die durch erste und zweite Trenn- oder Isolationswände (11, 12) begrenzt sind;
wobei der erste Bereich den Thyristor (GTO), realisiert in lateraler Form, und die Widerstandsbrücke (R2, R3) aufweist;
wobei der zweite Bereich den Schalter (T) und die Diode (Z) aufweist,
wobei der Schalter ein vertikal gebildeter Bipolar-Transistor ist;
wobei die Verbindung zwischen dem Kathoden-Anschluss (16) des Thyristors und dem Kollektor (44) des Transistors auf der Vorderseite gewährleistet ist.

10. Schaltkreis nach Anspruch 9, **dadurch gekennzeichnet, dass** er auf der N-Typ-Oberseite des Substrats (10) folgendes aufweist:
- in dem ersten Bereich:
eine erste, stark P-dotierte Anoden-Region (14), die mit einer ersten Metallisierung (M1) bedeckt ist;
eine zweite, stark N-dotierte Kathoden-Region (18), die mit einer zweiten Metallisierung (M2) bedeckt ist;
eine dritte, stark N-dotierte Region (24), die mit einer dritten Metallisierung (M3) beschichtet ist und in Kontakt mit dem Substrat (10) steht und dem Anoden-Anschluss entspricht;
eine vierte, stark P-dotierte Kathoden-Anschluss-Region (16), die von der ersten Trenn- oder Isolationswand (11) getrennt ist;
eine Kanal-Stopp-Region (54) zwischen der vierten Region und der ersten Wand;
eine fünfte, stark P-dotierte Region (22), die über die dritte Metallisierung (M3) mit der dritten Region (24) kurzgeschlossen ist und mit einer sechsten, schwach P-dotierten Region (20) in Kontakt steht, wobei die sechste Region ferner mit der vierten Region (16) in Kontakt steht und einen Widerstand (R1) zwischen dem Anoden- und dem Kathoden-Anschluss bildet;
schwach P-dotierte Regionen (26, 28), deren Ränder oder Enden einheitlich mit stark P-dotierten Bereichen (29, 30 und 31) sind, die mit jeweiligen Metallisierungen (M4, M5 und M6) beschichtet sind,
wobei eine der Metallisierungen (M4) eine P-dotierte Region (29), welche einem (R2) der Widerstände der Widerstandsbrücke (R2, R3) entspricht, und eine stark N-dotierte Region (33) kurzschließt; und
- in dem zweiten Bereich:
eine schwach P-dotierte Senke (41), die die Basis des Transistors (T) bildet und in der stark N-dotierte Regionen (42, 43) gebildet sind, die mit jeweiligen Metallisierungen (M8, M9) bedeckt sind und dem Emitter des Transistors und der Kathode der Diode entsprechen; und
um den Umfang der Senke herum einen stark N-dotierten Ring (53), der mit einer Metallisierung (M12) bedeckt ist und den Kollektor des Transistors bildet.
